# EUROPEAN PATENT APPLICATION

(11) **EP 2 384 101 A1**
(43) Date of publication of application: **02.11.2011**
(21) Application number: 10735737.8
(22) Date of filing: 21.01.2010
(51) Int. Cl.: H05K 1/09, B32B 15/01, C23C 28/00, C23C 30/00, C23F 1/18, H05K 3/06

(54) **ROLLED COPPER FOIL OR ELECTROLYTIC COPPER FOIL FOR ELECTRONIC CIRCUIT, AND METHOD FOR FORMING ELECTRONIC CIRCUIT USING SAME**

(30) Priority: 29.01.2009 JP 2009018441
(71) Applicant: JX Nippon Mining & Metals Corporation, Tokyo 100-8164 (JP)
(72) Inventor: YAMANISHI Keisuke, Hitachi-city Ibaraki 317-0056 (JP); KAMINAGA Kengo, Hitachi-city Ibaraki 317-0056 (JP); FUKUCHI Ryo, Hitachi-city Ibaraki 317-0056 (JP)
(74) Representative: Hoarton, Lloyd Douglas Charles
(86) International application number: PCT/JP2010/050707
(87) International publication number: WO 2010/087268

(57) **Abstract**

A rolled copper foil or electrolytic copper foil for an electronic circuit to be used for forming a circuit by etching, **characterized in** comprising a layer of metal of one or more types among a platinum group, gold and silver with an etching rate that is lower than the copper formed on an etching surface side of the rolled copper foil or the electrolytic copper foil, or alternatively comprising a layer of an alloy having the above-described metal as its main component. This invention aims to achieve the following upon forming a circuit by etching a copper foil of a copper clad laminate; specifically, to prevent sagging caused by the etching; to form a uniform circuit of the intended circuit width; to shorten the time of forming a circuit by etching as much as possible; to improve the etching properties in pattern etching; and to prevent the occurrence of short circuits and defects in the circuit width,

## Description

### TECHNICAL FIELD

The present invention relates to a rolled copper foil or electrolytic copper fail for an electronic circuit to be used for forming a circuit by etching, and to a method of forming an electronic circuit by using such rolled copper foil or electrolytic copper foil,

### BACKGROUND ART

A copper foil for a printed circuit is being widely used in electronic devices and electrical equipment, and this kind of copper foil for a printed circuit is generally bonded to a base material such as a synthetic resin board or a film with an adhesive or without it under high temperature and pressure to produce a copper clad laminate, a circuit is subsequently printed with the processes of resist application and exposure in order to form the intended circuit, etching treatment is further performed in order to remove any unwanted part of the copper foil, and various elements are soldered in order to form a printed circuit for electronic devices.

A copper foil that is used for such a printed circuit can be broadly classified as an electrolytic copper foil and a rolled copper foil depending on the production method, but both are used according to the type or quality demand of the printed circuit board.
These copper foils have a surface that is bonded to a resin base material and a non-adhesive surface, and they are respectively subject to special surface treatment (treatment process). In addition, there are cases where both surfaces are provided with a function of bonding with the resin; that is, double treatment process, for instance, with a copper foil that is used as the inner layer of a multi-layered printed wiring board.

An electrolytic copper foil is generally produced by electrodepositing copper on a rotating drum, and continuously peeling this to obtain a copper foil. At this point in the production process, the surface in contact With the rotating drum is a gloss surface, and the opposite surface has numerous irregularities (rough surface). Nevertheless, even with this kind of trough surface, it is standard to adhere copper particles of approximately 0.2 to 3 µm in order to further improve the adhesiveness with the resin substrate.
Moreover, there are also cases of reinforcing the foregoing irregularities and forming a thin plating layer thereon for preventing the facing of the copper particles. The foregoing series of steps is referred to as roughening treatment. This kind of roughening treatment is required not only for electrolytic copper foils, but also required for rolled copper foils, and similar roughening treatment is also performed for rolled copper foils.

The foregoing copper foils are used and subject to hot pressing or the continuous magnetization method to produce a copper clad laminate. Taking hot pressing as an example, this laminate is produced through the processes of synthesizing epoxy resin, impregnating phenol resin on a paper base material, drying this to produce a prepreg, combining said prepreg and the copper foil and performing heat pressure molding thereto with a pressing machine. Besides the above, there is a method of drying and fixing a polyimide precursor solution onto the copper foil, and forming a polyimide resin layer on the copper foil.

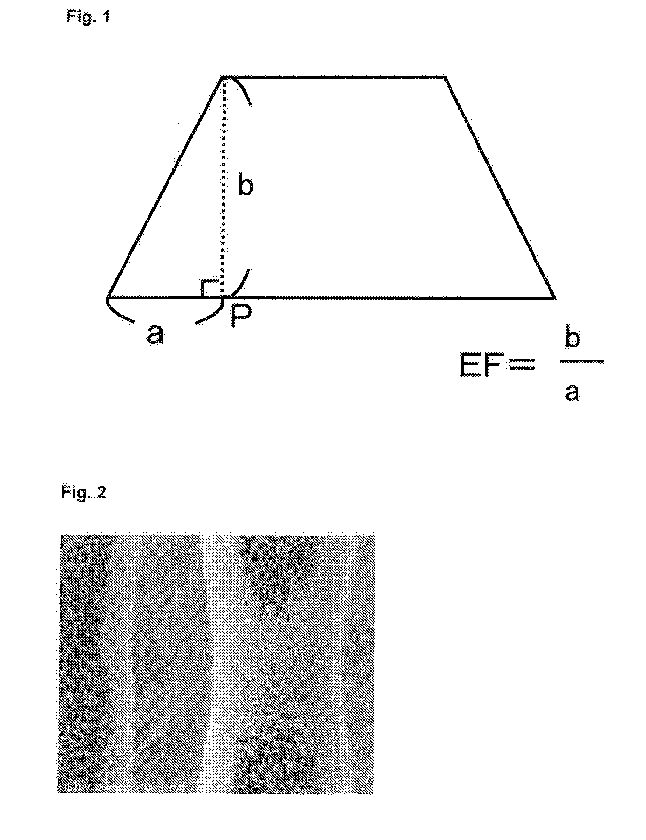

With the copper clad laminate produced as above, a circuit is printed with the processes of resist application and exposure, and etching treatment is further performed to remove any unwanted part of the copper foil. When forming a circuit by etching, a problem occurs that the circuit does not become the intended width.
This is caused by the copper portion of the copper foil circuit after etching performed downward from the surface of the copper foil; that is, etched in a manner which will widen toward the resin layer (cause sagging). Normally, the angle of the side face of the circuit becomes the "sagging" of approximately 50°, and in particularly if large "sagging" occurs, the copper circuit will short circuit in the vicinity of the resin substrate, and may become defective (refer to Fig. 2 described later),

It is necessary to reduce such "sagging" as much as possible. Thus, in order to prevent defective etching which widens toward the end, attempts have been made to reduce the "sagging" by prolonging the etching time and increasing the etching process.
Nevertheless, in the foregoing case, if there is a portion that has already reached a predetermined width dimension, such portion will be additionally etched, and the circuit width of that copper foil portion will become narrower by that much, and the uniform line width (circuit width) that is intended in the circuit design cannot be obtained. In there is a problem in that such portion (thinned portion) will generate heat and, in certain cases, become disconnected.
Under circumstances where the patterns of electronic circuits are becoming finer, problems caused by this kind of defective etching are still soften encountered today, and are becoming major issues in forming circuits.

In order to resolve the foregoing problems, the present inventors proposed a copper foil of forming a metal or alloy layer with an etching rate that is lower than copper on the copper foil on the etching surface side (refer to Patent Document 1). As the metal or alloy in this case, used are nickel, cobalt and their alloys,
Upon designing a circuit, since the etching solution will infiltrate from the resist application side; that is, from the surface of the copper foil, if there is a metal or alloy layer with a low etching rate immediately below the resist, the etching of the copper foil portion in the vicinity thereof is inhibited, and the etching of the other copper foil portions will advance. Thus, it was possible to yield the effect of reducing the "sagging" and forming a circuit with a uniform width. Further, it could be said that there was a vast improvement in forming a steep circuit of achieving 63° to 75° as the angle of the side face of the circuit, compared to the conventional technology.

Subsequently, the reduction of the foregoing "sagging" is being further demanded pursuant to the refinement and densification of the circuit, and there are demands for the inclined angle of the side face of the circuit to exceed a steeper 75°, and exceed 80° if possible. When forming a metal or metal alloy film with a lower etching rate than copper on the copper foil as in Patent Document 1, it is assumed that the other materials will yield similar effects as Patent Document 1 if the effect is dependent on the difference in the etching rate in comparison to copper,
Moreover, other problems arose at the stage of making further improvements. Specifically, after forming the circuit, it was necessary to remove the resin and the metal or alloy layer with a low etching rate, which was formed for preventing the "sagging," using soft etching. In addition, it was also necessary to perform high-temperature treatment to the copper foil upon attaching the resin in the process of preparing a copper clad laminate with a copper foil including a metal or alloy layer with a low etching rate, and thereby forming an electronic circuit.

With respect to the former, for shortening the time required for the etching and removal process and achieving a clean removal, it is necessary to make the thickness of the metal or alloy layer with a low etching rate as thin as possible. With respect to the latter, since it is exposed to heat, the base copper layer is oxidized (commonly called "tarnish" since discoloration occurs), and there are problems in that the etching properties may deteriorate in the pattern etching, and defects such as short circuits or deterioration in the controllability of the circuit width may occur due to the deterioration in the resist application properties (such as uniformity or adhesion) or the excessive etching of the interfacial oxide in the etching process. Thus, it is demanded that additional improvements be made, or different materials be used as a substitute therefor.

Patent Document 1: Japanese Published Unexamined Patent Application No. 2002-176242
Patent Document 2: Japanese Published Unexamined Patent Application No. 2006-261270

### DISCLOSURE OF THE INVENTION

An object of this invention is to obtain a rolled copper foil or electrolytic copper foil for an electronic circuit to be used for forming a circuit by etching, and a method of forming an electronic circuit by using such rolled copper foil or electrolytic copper foil so as to achieve the following upon forming a circuit by etching a copper foil of a copper clad laminate; specifically, to prevent sagging caused by the etching so as to form a uniform circuit of the intended circuit width by achieving a steeper angle than that of conventional technology, and to prevent the occurrence of short circuits and defects in the circuit width.

The present inventors discovered that it is possible to form a steep copper circuit with less "sagging" than conventionally known nickel, cobalt and the like and form a circuit with a uniform circuit width which is free from sagging by forming a layer of metal of one or more types among a platinum group, gold and silver, or alternatively a layer of an alloy having the foregoing metal as its main component on an etching surface side of a rolled copper foil or an electrolytic copper foil, and adjusting the etching rate in the thickness direction of the copper foil,

Based on the foregoing discovery, the present invention provides:
1. A rolled copper foil or electrolytic copper foil for an electronic circuit to be used for forming a circuit by etching, comprising a layer of metal of one or more types among a platinum group, gold and silver, or a layer of an alloy having the said metal as its main component, with an etching rate that is lower than the copper formed on an etching surface side of the rolled copper foil or the electrolytic copper foil;
2. The rolled copper foil or electrolytic copper foil for an electronic circuit according to paragraph 1 above, wherein the layer (A) with a lower etching rate than the copper is platinum or platinum alloy;
3. The rolled copper foil or electrolytic copper foil for an electronic circuit according to paragraph 1 above, wherein the layer (A) with a lower etching rate than the copper is platinum alloy, and the platinum ratio of the platinum alloy exceeds 50 wt%; and
4. The rolled copper foil or electrolytic copper foil for an electronic circuit according to paragraph 1 or paragraph 2 above, wherein the layer (A) with a lower etching rate than the copper is platinum alloy, and the alloy component contained in the platinum alloy is at least one or more types of elements selected among zinc, phosphorus, boron, molybdenum, tungsten, nickel, iron and cobalt.

The present invention additionally provides:
5. The rolled copper foil or electrolytic copper foil for an electronic circuit according to any one of paragraphs 1 to 4 above, further comprising a heat resistance layer (B) above or below the layer (A); and
6. The rolled copper foil or electrolytic copper foil for an electronic circuit according to any one of paragraphs 1 tao 5 above, wherein the heat resistance layer (B) is a layer made of either zinc or zinc alloy, and the zinc alloy contains, as the alloy element, one or more types selected from a group of a platinum group element, gold, a palladium group element and silver.

The present invention further provides:
7. The rolled copper foil or electrolytic copper foil for an electronic circuit according to any one of paragraphs 1 to 6 above, further comprising a chromium layer or a chromate layer and/or a silane treated layer on the heat resistance layer (B).

The present invention further provides:
8. A method of forming an electronic circuit by etching a copper foil of a copper clad laminate made of a rolled copper foil or an electrolytic copper foil, wherein a layer of one type of metal of a platinum group, gold and silver, or a layer of an alloy having the foregoing metal as its main component with an etching rate that is lower than copper is formed on an etching surface side of the copper foil, and the copper foil is etched using aqueous ferric chloride or aqueous copper chloride to remove any unwanted portion of the copper so as to form a copper circuit; and
9. A method of forming an electronic circuit by etching a copper foil of a copper clad laminate made of a rolled copper foil or an electrolytic copper foil, wherein the rolled copper foil or the electrolytic copper foil for an electronic circuit according to any one of paragraphs 1 to 12 above is used to prepare a copper clad laminate with the layer (A) with a lower etching rate as the etching surface, and the copper foil is etched with aqueous ferric chloride or aqueous copper chloride to remove any unwanted portion of the copper so as to form a copper circuit.

### DISCLOSURE OF THE INVENTION

The present invention yields an effect of being able to form a uniform circuit of the intended circuit width upon forming a circuit by etching a copper foil as a result of forming a steep circuit with minimal "sagging" based on etching,
It is thereby possible to provide a rolled copper foil or electrolytic copper foil for an electronic circuit capable of preventing the occurrence of short circuits and defects in the circuit width, and further provide a method of forming a superior electronic circuit.

### BRIEF DESCRIPTION OF THE INVENTION

Fig. 1 is a diagram explaining the outline of the calculation method of the etching factor (EF).
Fig. 2 is a photograph showing the occurrence of "sagging" during the formation of a copper circuit and the short-circuiting of the copper foil in the vicinity of the resin substrate.
Fig. 3 is a photograph showing the circuit formed by Example 1 and its cross section.
Fig. 4 is a photograph showing the circuit formed by Comparative Example 2 and its cross section.

### BEST MODE FOR CARRYING OUT THE INVENTION

The rolled copper foil or electrolytic copper foil for an electronic circuit to be used for forming a circuit by etching according to the present invention comprises a layer of metal of one or more types among a platinum group, gold and silver, or alternatively a layer of an alloy having the foregoing metal as its main component, both with an etching rate that is lower than the copper formed on an etching surface side of the rolled copper foil or the electrolytic copper foil.
The copper foil prepared as described above is used to form a copper clad laminate. This copper foil is applicable to both an electrolytic copper foil and a rolled copper foil, and to both a roughened surface (M surface) and a gloss surface (S surface) in the case of an electrolytic copper foil. But as the etching surface, the gloss surface side is usually used. A rolled copper foil includes high purity copper foils and alloy copper foils with improved strength, and the present invention covers all of these copper foils.

A resist is applied to the surface of the copper clad laminate, a pattern is exposed by masking, and, after forming a resist pattern by development, it is immersed in an etching solution.
The layer of metal of one or more types among a platinum group, gold and silver or the layer of an alloy having the metal as its main component which inhibits the etching is positioned close to the resist on the copper foil, as a result of the etching of the copper layer positioned away from the layer of metal of one or more types among a platinum group, gold and silver or the layer of an alloy having the metal as its main component advancing at a rate that is higher than the etching rate in the vicinity of the foregoing layer, the etching of the copper foil on the resist side will advance so that that the copper circuit becomes approximately vertical, and a rectangular copper foil circuit is thereby formed.

Preferably, the layer of metal of one or more types among a platinum group, gold and silver is 50 µg/dm² or more and 1000 µg/dm² or less. When the foregoing layer is less than 50 µg/dm², the copper circuit is etched substantially vertically, and the effect of the layer where the rectangular copper foil circuit is to be formed will be minimal. Meanwhile, if the foregoing layer exceeds 1000 µg/dm², the effect of the layer where the rectangular copper foil circuit is to be formed will become saturated. If the foregoing layer becomes thick, etching becomes impossible, since fundamentally, noble metals do not dissolve in an aqueous ferric chloride solution (etching solution). And when such layer is to be removed after the circuit is formed, a thinner layer is preferable since a thinner layer can be removed easily.

Since the etching rate of the layer (A) as the layer of metal of one or more types among a platinum group, gold and silver or the layer of an alloy having the metal as its main component is sufficiently slower than copper relative to the etching solution (aqueous copper chloride solution, aqueous ferric chloride solution, etc.) that is used for forming an electronic circuit pattern on the copper clad laminate, the effect of improving the etching factor is yielded.

Along the layer of metal of one or more types among a platinum group, gold and silver or the layer of an alloy having the metal as its main component, platinum or platinum alloy is particularly effective.
As the alloy components contained in the platinum alloy, any generally known alloy may be used. For example, an alloy of at least one or more types of elements selected among zinc, phosphorus, boron, molybdenum, tungsten, Nickel, iron and cobalt has an etching rate that is lower than copper, and it has been confirmed that they yield the effect of being able to improve the etching factor.

A heat resistance layer (B) can also be formed above or below the layer (A) as the layer of metal of one or more types among a platinum group, gold and silver or the layer of an alloy having the metal as its main component. Moreover, the heat resistance layer is desirably a layer made of either zinc or zinc alloy, and the zinc alloy contains, as the alloy element, one or more types selected from a group of a platinum group element, gold, a palladium group element and silver.
A chromium layer or a chromate layer and/or a silane treated layer can also be formed on the layer (A) as the layer of metal of one or more types among a platinum group, gold and silver or the layer of an alloy having the metal as its main component.

The total zinc content containing in the heat resistance layer (B) and the layer (A) in the rolled copper foil or electrolytic copper foil for an electronic circuit of the present invention is desirably 30 µg/dm2 to 1000 µg/dm2 based on metal zinc conversion.
If the total zinc content is less than 30 µg/dm², there is not effect for oxidation resistance (tarnish improvement). Moreover, if the total zinc content exceeds 1000 µg/dm², the effect becomes saturated and even diminishes the effect of the laser (A), and, therefore, it is preferably 30 µg/dm² to 1000 µg/dm² based on metal zinc conversion.

Further, if the chromium layer or the chromate layer is to be provided in the rolled copper foil or electrolytic copper foil of an electronic circuit according to the present invention, the amount of chromium is set to be 100 µg/dm² or less based on metal chromium conversion. When forming the silane-treated layer, the amount of silane is preferably 20 µg/dm² or less based on silicon elemental conversion. This aims to inhibit differences in the etching rate relative to the pattern etching solution.

The present invention can also provide a method of forming an electronic circuit by etching a copper foil of a copper clad laminate made of a rolled copper foil or an electrolytic copper foil, wherein a layer of one type of metal oaf a platinum group, gold and silver, or alternatively a layer of an alloy having the foregoing metal as its main component, both with an etching rate that is lower than copper is formed on an etching surface side of the copper foil, and the copper foil is etched using an aqueous ferric chloride solution or an aqueous copper chloride solution to remove any unwanted portion of the copper so as to form a copper circuit.
Any of the foregoing etching solutions may be used, but in particular the aqueous ferric chloride solution is effective, because the etching of a fine circuit take time, and the aqueous ferric chloride solution has a higher etching rate than the aqueous copper chloride solution.

The present invention also provides a method of forming an electronic circuit by etching a copper foil of a copper clad laminate made of a rolled copper foil or electrolytic copper foil, wherein the rolled copper foil or electrolytic copper foil for an electronic circuit according to any one of paragraphs 1 to 8 is etched with an aqueous ferric chloride solution or ain aqueous copper chloride solution to remove unwanted portions of the copper foil and thereby form a copper circuit. This method is applicable to both a rolled copper foil and an electrolytic copper foil for an electronic circuit.

### Examples of preferred deposition conditions are shown below.

The layer of one type of metal of a platinum group, gold or silver, or alternatively a layer of an alloy having the foregoing metal as its main component, such as platinum-zinc alloy, platinum-phosphorus alloy, platinum-molybdenum alloy, platinum-tungsten alloy, platinum-iron alloy and platinum-cobalt alloy, can be deposited with the sputtering method, or a wet plating method such as the electrolytic plating or electroless plating methods.

### (Sputtering conditions)

Device: E-102 Ion Sputtering Device manufactured by HITACHI
Degree of vacuum: 0.01 to 0.1 Torr
Current: 5 to 30 mA
Time: 5 to 150 seconds

### (Zinc plating)

Zn: 1 to 20 g/L
pH: 3 to 3.7
Temperature: Ordinary temperature to 60°C
Current density Dk: 1 to 15 A/dm²
Time: 1 to 10 seconds

### (Chromium plating conditions)

K₂Cr₂O₇ (Na₂Cr₂O₇ or CrO₃)
Cr: 40 to 300 g/L
H₂SO₄: 0.5 to 10.0 g/L
Bath temperature: 40 to 60°C
Current density Dk: 0.01 to 50 A/dm²
Time: 1 to 100 seconds
Anode: Pt-plated Ti plate, stainless steel plate, lead plate, etc.

### (Chromate treatment conditions)

(a) Example of electrolytic chromate treatment
   CrO₃ or K₂Cr₂O₇: 1 to 12 g/L
   Zn(OH)₂ or ZnSO₄·7H₂O: 0(0.05) to 10 g/L
   Na₂SO₄: 0(0.05) to 20 g/L
   pH: 2.5 to 12.5
   Temperature: 20 to 60°C
   Current density: 0.5 to 5 A/dm²
   Time: 0.5 to 20 seconds

### (Nickel plating)

Ni: 10 to 40 g/L
pH: 2.5 to 3.5
Temperature: Ordinary temperature to 60°C
Current density Dk: 2 to 50 A/dm²
Time: 1 to 4 seconds

### (Silane treatment conditions)

Silane is selected from the various systems shown below.
Concentration: 0.01 wt% to 5 wt%
Type: olefin system silane, epoxy system silane, acrylic silane, amino system silane, mercapto system silane
Silane dissolved in alcohol is diluted with water up to a predetermined concentration, and applied to the copper foil surface,

### (Method of analyzing amount of platinum adhesion)

In order to analyze platinum-treated surface, the opposite surface is pressed and prepared with FR-4 resin, and subsequently masked. A sample thereof is dissolved in aqua regia until the surface treatment coating is dissolved, the solution inside the beaker is diluted, and the quantitative analysis of platinum is performed with atomic absorption spectrometry.
The analysis of other platinum groups, gold and silver can also be performed similarly.

### (Method of analyzing amount of zinc and chromium adhesion)

In order to analyze the treated surface, the opposite surface is pressed and manufactured with FR-4 resin, A sample thereof is boiled for 3 minutes in nitric acid with a concentration of 30% to dissolve the treated layer. Using this solution, the quantitative analysis of zinc and chromium is performed with atomic absorption spectrometry.

### (Consideration of thermal influence)

During the stage of producing the copper-clad laminate (CCL), the copper foil is exposed to heat Due to this heat, the etching improvement treated layer provided to the copper foil superficial layer will diffuse to the copper layer. Thus, the initially expected etching improvement effect will diminish, and the etching factor tends to decrease. In light of the above, in order to yield the same effect as a non-diffused state, it is necessary to increase the amount of adhesion of the improvement treated layer by 1.1 to 2 times in consideration of the amount of heat to which the copper foil is exposed during the production of the CCL.

When etching the copper foil of the copper clad laminate, after forming a metal or alloy layer with a lower etching rate than copper on the etching surface side of the copper foil, the copper foil is etched using an aqueous copper chloride solution or an aqueous ferric chloride solution.
As a result of performing etching in the foregoing conditions, it is possible to achieve an etching factor of 3.7 or more; that is, it is possible to make the inclination angle of the side face of the circuit between the etching side surface of the copper foil circuit and the resin substrate to be 75 degrees or more. A more preferable inclination angle is within the range of 80 to 95 degrees, and the present invention is able to achieve such an inclination angle, and it is thereby possible to form a rectangular etched circuit that is free from sagging.

### [Examples]

The Examples and Comparative Example of the present invention are now explained. Incidentally, these Examples are merely illustrative, and the present invention shall in no way be limited thereby. In other words, various modifications and other embodiments based on the technical spirit claimed in the claims shall be covered by the present invention as a matter of course.

### (Example 1)

A rolled copper foil had a film thickness of 18 µm. The surface roughness Rz of this rolled copper foil was 0.7 µm. Platinum of 200 µg/dm² was formed on this rolled copper foil in the foregoing platinum sputtering conditions.
And the copper foil was bonded to a resin substrate with the side opposite to the surface provided with the platinum layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as fellows.
(Etching conditions)
Aqueous ferric chloride solution: (37 wt%, Baum'e degree: 40°)
Solution temperature: 50°C
Spray pressure: 0.15 MPa

### (Circuit forming conditions)

Circuit pitch: There are two types of circuit pitches; namely, a 30 µm pitch and a 50 µm pitch, and the circuit pitch is changed according to the thickness of the copper foil. In the case of Example 1, the following conditions were adopted since a copper foil with a thickness of 18 µm was used.
(50µm pitch circuit formation)
Resist L/S = 33 µm/17 µm; finished circuit top (upper part) width; 15 µm; etching time: around 105 seconds

### (Measurement conditions of etching factor)

In cases where etching is performed in a manner which widens toward the end (cases where sagging occurs), and on the assumption that the circuit was etched vertically, with the intersection point of the perpendicular from the upper surface of the copper foil and the resin substrate as Point P and the distance of the sagging length from Point P as a, the etching factor shows the ratio b/a of [distance] a and thickness b of the copper foil, and the larger the numerical value of the etching factor, the greater the inclination angle will be, which means that there will be no etching residue and sagging will diminish.
The outline of the calculation method of the etching factor (EF) is shown in Fig. 1. As shown in Fig. 1, the calculation is performed as EF =b/a. By using this etching factor, the quality of the etching properties can be easily determined.

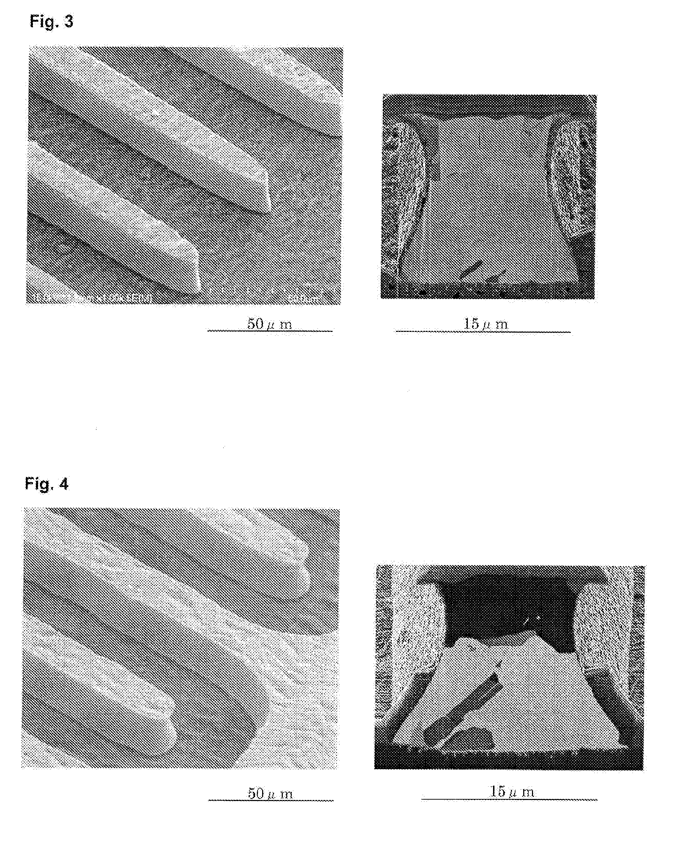

Etching was performed in the foregoing conditions. Thus, etching proceeded approximately vertical from the resist side of the side surface of the copper circuit toward the resin substrate side, and a rectangular copper foil circuit was formed. And, the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 81 degrees, and an approximately rectangular copper foil circuit was formed. The etching factor was 6.2 with the 50 µm pitch.
A favorable etching circuit was thereby obtained as shown in Fig. 3.

### (Example 2)

As with Example 1, a rolled copper foil had a film Thickness of 18 µm. The surface roughness Rz of this rolled copper foil was 0.7 µm, Platinum of 500 µg/dm² was formed on this rolled copper foil in the foregoing platinum sputtering conditions.
And the copper foil was bonded to a resin substrate with the side opposite to the surface provided with the platinum layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (50 µm pitch circuit formation)

Resist L/S =33 µm/17 µm; finished circuit top (upper part) width: 15 µm; etching time: around 105 seconds

### (Measurement conditions of etching factor)

The measurement conditions of the etching factor were the same as foregoing Example 1 and the explanation thereof is omitted. Etching was performed in the foregoing conditions. Consequently, etching proceeded approximately vertical from the resist side of the side surface of the copper circuit toward the resin substrate side, and a rectangular copper foil circuit was formed.
And the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 82 degrees, and an approximately rectangular copper foil circuit was formed. The etching factor was 7 with the 50 µm pitch.
A favorable etching circuit was thereby obtained.

### (Example 3)

In this Example, a rolled copper foil had a film thickness of 9 µm. The surface roughness Rz of this rolled copper foil was 0.7 µm. Platinum of 900 µg/dm² was formed on this rolled copper foil in the foregoing platinum sputtering conditions.
And the copper foil was bonded to a resin substrate with the side opposite to the surface provided with the platinum layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (30 µm pitch circuit formation)

Since Example 3 used a copper foil having a thickness of 9 µm, the following conditions were used,
Resist L/S = 25 µm/5 µm, finished circuit top (upper part) width: 10 µm, etching time: around 76 seconds

Etching was performed in the foregoing conditions. Thus, etching proceeded approximately vertical from the resist side of the side surface of the copper circuit toward the resin substrate side, and a rectangular copper foil circuit was formed. And, the inclination angle of the etched copper foil was measured (incidentally, this is the minimum value of the inclination angle in the circuit length of 100 µm). The etching factor was examined, and the results are shown in Table 1.

As shown in Table 1, the average value of the horizontal inclination angle was 81 degrees, and an approximately rectangular copper foil circuit was formed. The etching factor was 6.5 with the 30 µm pitch.
A favorable etching circuit was thereby obtained.

### (Example 4)

In this Example, an electrolytic copper foil had a film thickness of 5 µm. The surface roughness Rz of this electrolytic copper foil was 3 µm. Platinum of 75 µg/dm² was formed on this electrolytic copper foil in the foregoing platinum sputtering conditions,
And the copper foil was bonded to a resin substrate with the side opposite to the surface provided with the platinum layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure; 0.15 MPa

### (30 µm pitch circuit formation)

Since Example 4 used a copper foil having a thickness of 5 µm, the following conditions were used.
Resist L/S = 25 µm/5 µm, finished circuit top (upper part) width: 10 µm, etching time: around 48 seconds

Etching was performed in the foregoing conditions. Thus, etching proceeded approximately vertical from the resist side of the side surface of the copper circuit toward the resin substrate side, and a rectangular copper foil circuit was formed. And, the inclination angle of the etched copper foil was measured (incidentally, this is the minimum value of the inclination angle in the circuit length of 100 µm). The etching factor was examined, and the results are shown in Table 1.

As shown in Table 1, the average value of the horizontal inclination angle was 81 degrees, and an approximately rectangular copper foil circuit was formed. The etching factor was 6.5 with the 30 µm pitch.
A favorable etching circuit was thereby obtained.

### (Example 5)

As with Example 1, a rolled copper foil had a film thickness of 18 µm. The surface roughness Rz of this rolled copper foil was 0.7 µm. Gold of 450 µg/dm² was formed on this rolled copper foil in the foregoing gold sputtering conditions.
And the copper foil was bonded to a resin substrate with the side opposite to the surface provided with the gold layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (50 µm pitch circuit formation)

Resist L/S = 33 µm/17 µm, finished circuit top (upper part) width: 15 µm, etching time: around 105 seconds

### (Measurement conditions of etching factor)

The measurement conditions of the etching factor were the same as foregoing Example 1 and the explanation thereof is omitted. Etching was performed in the foregoing conditions. Consequently, etching proceeded approximately vertical from the resist side of the side surface of the copper circuit toward the resin substrate side, and a rectangular copper foil circuit was formed.
And, the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 82 degrees, and an approximately rectangular copper foil circuit was formed. The etching factor was 6.9 with the 50 µm pitch.
A favorable etching circuit was thereby obtained.

### (Example 6)

As with Example 1, a rolled copper foil had a film thickness of 18 µm. The surface roughness Rz of this rolled copper foil was 0.7 µm. Palladium of 550 µg/dm² was formed on this rolled copper foil in the foregoing palladium sputtering conditions.
And the copper foil was bonded to a resin substrate with the side opposite to the surface provided with the palladium layer as the adhesive surface.

Subsequently, ten lines of a circuit where printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (50 µm pitch circuit formation)

Resist L/S = 33 µm/17 µm, finished circuit top (upper part) width: 15 µm, etching time: around 105 seconds

### (Measurement conditions of etching factor)

The measurement conditions of the etching factor were the same as foregoing Example 1 and the explanation thereof is omitted. Etching was performed in the foregoing conditions. Consequently, etching proceeded approximately vertical from the resist side of the side surface of the copper circuit toward the resin substrate side, and a rectangular copper foil circuit was formed.
And, the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 82 degrees, and an approximately rectangular copper foil circuit was formed. The etching factor was 6.8 with the 50 µm pitch.
A favorable etching circuit was thereby obtained.

### (Example 7)

As with Example 1, a rolled copper foil had a film thickness of 18 µm. The surface roughness Rz of this rolled copper foil was 0.7 µm. 95% Pt-5% Pd of 300 µg/dm² was formed on this rolled copper foil in the foregoing 95% Pt-5% Pd sputtering conditions.
And the copper foil was bonded to a resin substrate with the side opposite to the surface provided with the 95% Pt-5% Pd layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (50 µm pitch circuit formation)

Resist L/S = 33 µm/17 µm, finished circuit top (upper part) width: 15 µm, etching time: around 105 seconds

### (Measurement conditions of etching factor)

The measurement conditions of the etching factor were the same as foregoing Example 1 and the explanation thereof is omitted. Etching was performed in the foregoing conditions. Consequently, etching proceeded approximately vertical from the resist side of the side surface of the copper circuit toward the resin substrate side, and a rectangular copper foil circuit was formed.
And, the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 82 degrees, and an approximately rectangular copper foil circuit was formed. The etching factor was 6.8 with the 50 µm pitch.
A favorable etching circuit was thereby obtained.

### (Example 8)

As with Example 1, a rolled copper foil had a film thickness of 18 µm. The surface roughness Rz of this rolled copper foil was 0.7 µm. A sputtered layer of Au of 190 µg/dm² Pt of 210 µg/dm² (dual layer) was formed on this rolled copper foil in the foregoing sputtering conditions.
And the copper foil was bonded to a resin substrate with the side opposite to the surface provided with the dual sputtered layer as the adhesive surface.

Subsequently, ten lines of a circuit were printed with the processes of resist application and exposure, and etching treatment was further performed to remove any unwanted part of the copper foil. The conditions of etching, circuit forming and measurement of the etching factor were as follows.
(Etching conditions)
Aqueous ferric chloride solution: (37 wt%, Baum'e degree: 40°)
Solution temperature: 50°C
Spray pressure: 0.15 MPa

### (50 µm pitch circuit formation)

Resist L/S = 33 µm/17 µm, finished circuit top (upper part) width: 15 µm, etching time: around 105 seconds

### (Measurement conditions of etching factor)

The measurement conditions of the etching factor were the same as foregoing Example 1 and the explanation thereof is omitted. Etching was performed in the foregoing conditions. Consequently, etching proceeded approximately vertical from the resist side of the side surface of the copper circuit toward the resin substrate side, and a rectangular copper foil circuit was formed.
And, the inclination angle of the etched copper foil was measured (incidentally, this is the minimum value of the inclination angle in the circuit length of 100 µm). The etching factor was examined, and the results are shown in Table 1.
As shown in Table 1, the average value of the horizontal inclination angle was 82 degrees, and an approximately rectangular copper foil circuit was formed. The etching factor was 6.9 with the 50 µm pitch.
A favorable etching circuit was thereby obtained.

A zinc plated layer of 45 µg/dm² or nickel plated layer of 900 µg/dm² were formed on the same rolled copper foil as Example 1 (where platinum of 200 µg/dm² was formed on a rolled copper foil of 18 µm in the platinum sputtering conditions) to confirm the oxidation resistance (tarnish improvement) with the following testing method, and favorable results were obtained.

### (Tarnish experiment)

Under ambient atmosphere, [the copper foil] was retained at 240°C for 10 minutes to confirm the status of discoloration. These conditions are based on the assumption of bonding the copper foil provided with a zinc plated layer or nickel plated layer to the resin substrate as the etching side and thereby forming a copper clad laminate.

### (Comparative Example 1)

A rolled copper foil had a film thickness of 18 µm. The surface roughness Rz of this rolled copper foil was 0.7 µm. A nickel plated layer of 1200 µg/dm² was formed on this rolled copper foil in the foregoing nickel plating conditions, and subsequently bonded to a resin substrate.
Subsequently, as with Example 1, ten lines of a circuit were printed with the processes of resist application and exposure, and etching treatment was further performed to remove any unwanted part of the copper foil.
Since the etching conditions, measurement conditions of the etching factor, and tarnish experiment (excluding the circuit forming conditions) were the same as Example 1, the description of conditions that overlap with Example 1 is omitted.

### (50 µm pitch circuit formation)

Resist L/S = 33 µm/17 µm, finished circuit top (upper part) width: 15 µm, etching time: around 105 seconds
Etching was performed in the foregoing conditions. Consequently, the average value of the horizontal inclination angle was 73 degrees, and a substantially rectangular copper foil circuit was formed. The etching factor was 3.3 with the 50 µm pitch. As shown in Fig. 4, an etching circuit that is substantially rectangular but with a slightly small inclination angle and a slightly small etching factor was obtained.

### (Comparative Example 2)

A rolled copper foil had a film Thickness of 18 µm. The surface roughness Rz of this rolled copper foil was 0.7 µm. A platinum layer of 25 µg/dm² was formed on this rolled copper foil in the foregoing platinum plating conditions. The copper foil was bonded to a resin substrate with the side opposite to the platinum layer as the adhesive surface.

Subsequently, as with Example 1, ten lines of a circuit were printed with the processes of resist application and exposure, and etching treatment was further performed to remove any unwanted part of the copper foil.
Since the etching conditions, measurement conditions of the etching factor, and tarnish experiment (excluding the circuit forming conditions) were the same as Example 1, the description of conditions that overlap with Example 1 is omitted.
(50 µm pitch circuit formation)
Resist L/S = 33 µm/17 µm, finished circuit top (upper part) width: 15 µm, etching time: around 105 seconds

Etching was performed in the foregoing conditions. Consequently, etching proceeded from the resist side of the side surface of the copper circuit toward the resin substrate side, but a copper foil circuit that slightly widened toward the end was formed. Subsequently, the inclination angle of the etched copper foil was measured (incidentally, the minimum value of the inclination angle in the circuit length of 100 µm was measured).
As the foregoing results similarly shown in Table 2, the average value of the horizontal inclination angle was 52 degrees, and a trapezoid copper foil circuit with inferior etching properties was formed. The etching factor was inferior at 1.3 with the 50 µm pitch.

### (Comparative Example 3)

An electrolytic copper foil had a film thickness of 5 µm. The surface roughness Rz of this electrolytic copper foil was 3 µm. A nickel plated layer of 580 µg/dm² was formed on the gloss (S) surface of this electrolytic copper foil in the foregoing nickel plating conditions. And the copper foil was bonded to a resin substrate with the side opposite to the surface formed with the nickel plated layer as the adhesive surface.

Subsequently, as with Example 1, ten lines of a circuit were printed with the processes of resist application and exposure, and etching treatment was further performed to remove any unwanted part of the copper foil.
Since the etching conditions, measurement conditions of the etching factor, and tarnish experiment (excluding the circuit forming conditions) were the same as Example 1, the description of conditions that overlap with Example 1 is omitted.
(30 µm pitch circuit formation)
Resist L/S = 25 µm/5 µm, finished circuit top (upper part) width: 15 µm, etching time: around 48 seconds

Etching was performed in the foregoing conditions. Consequently, the average value of the horizontal inclination angle was 74 degrees, and a substantially rectangular copper foil circuit was formed, The etching factor was 3.5 with the 30 µm pitch (incidentally, this is the minimum value of the inclination angle in the circuit length of 100 µm).
As the results shown in Table 2, an etching circuit that is substantially rectangular but with a slightly small inclination angle and a slightly small etching factor was obtained.

As evident from Table 1, with a platinum or platinum alloy layer, a substantially rectangular copper foil circuit was formed with both the rolled copper foil and the electrolytic copper foil, and an extremely favorable etching circuit was obtained.
Meanwhile, those that did not satisfy the conditions of the present invention had a slightly small eteching factor and were no longer steep even though they were substantially rectangular, and a trapezoid copper foil circuit with considerable sagging was formed.
Accordingly, the effect of realizing 75 degrees or more as an inclination angle of the side face of the circuit is not limited to platinum or platinum alloy, and similar results were also obtained with a layer of metal of one or more types among other platinum groups, gold and silver, or alternatively a layer of an alloy having the foregoing metal as its main component.

**[Table 1]**

| | Base Foil | Foil Thickness (µm) | Pt Amount (µ g/dm²) | EF 30 µm pitch | EF 50 µ m pitch | Inclination Angle (degrees) |
|---|---|---|---|---|---|---|
| Example 1 | Rolled Copper Foil | 18 | 200 | | 6.2 | 81 |
| Example 2 | Rolled Copper Foil | 18 | 500 | | 7 | 82 |
| Example 3 | Rolled Copper Foil | 9 | 900 | 6.5 | | 81 |
| Example 4 | Electrolytic Copper Foil | 5 | 75 | 6.5 | | 81 |
| Example 5 | Rolled Copper Foil | 18 | A | | 6.9 | 82 |
| Example 6 | Rolled Copper Foil | 18 | B | | 6.8 | 82 |
| Example 7 | Rolled Copper Foil | 18 | C | | 6.8 | 82 |
| Example 8 | Rolled Copper Foil | 18 | D | | 6.9 | 82 |

| | | | | | | |
|---|---|---|---|---|---|---|
| EF: Etching Factor A: 450 µg/dm² Au Sputtering Layer B: 550 µg/dm² Pd Sputtering Layer C: 300 µg/dm² 95%Pt-5% Pd Sputtering Layer D: Double Spattering layers with Au 190 µg/dm² on Pt210 µg/dm² | | | | | | |

**[Table 2]**

| | Base Foil | Foil Thickness (µm) | Pt Amount (µg/dm²) | EF 30 µm pitch | EF 50 µm pitch | Inclination Angle (degrees) |
|---|---|---|---|---|---|---|
| Comparative Example 1 | Rolled Copper Foil | 18 | A | | 3.3 | 73 |
| Comparative Example 2 | Rolled Copper Foil | 18 | 25 | | 1.3 | 52 |
| Comparative Example 3 | Electrolytic Copper Foil | 5 | B | 3.5 | | 74 |

| | | | | | | |
|---|---|---|---|---|---|---|
| EF: Etching Factor A: 1200 µg/dm² Nickel Plated Layer B: 580 µg/dm² Nickel Plated Layer | | | | | | |

### INDUSTRIAL APPLICABILITY

The present invention yields the effect of forming a uniform circuit of the intended circuit width upon forming a circuit by etching a copper foil, and yields the additional effects of being able to prevent sagging caused by the etching, shorten the time of forming a circuit by etching. In addition, since it is thereby possible to improve the etching properties in pattern etching and to prevent the occurrence of short circuits and defects in the circuit width based on the layer of metal of one or more types among a platinum group, gold and silver, or alternatively a layer of an alloy having the foregoing metal as its main component with an etching rate that is lower than the copper, the present invention can be used as a copper clad laminate (rigid or flexible), and also used to form an electronic circuit of a printed substrate.

## Claims

1. A rolled copper foil or electrolytic copper foil for an electronic circuit to be used for forming a circuit by etching, comprising a layer of metal of one or more types among a platinum group, gold and silver or a layer of an alloy having the foregoing metal as its main component with an etching rate that is lower than the copper formed on an etching surface side of the rolled copper foil or the electrolytic copper foil,

2. The rolled copper foil or electrolytic copper foil for an electronic circuit according to claim 1, wherein the layer (A) with a lower etching rate than the copper is platinum or platinum alloy.

3. The rolled copper foil or electrolytic copper foil for an electronic circuit according to claim 1, wherein the layer (A) with a lower etching rate than the copper is platinum alloy, and the platinum ratio of the platinum alloy exceeds 50 wt%.

4. The rolled copper foil or electrolytic copper foil for an electronic circuit according to claim 1 or claim 2, wherein the layer (A) with a lower etching rate than the copper is platinum alloy, and the alloy component contained in the platinum alloy is at least one or more types of elements selected among zinc, phosphorus, boron, molybdenum, tungsten, nickel, iron and cobalt.

5. The rolled copper foil or electrolytic copper foil for an electronic circuit according to any one of claims 1 to 4, further comprising a heat resistance layer (B) above or below the copper layer.

6. The rolled copper foil or electrolytic copper foil for an electronic circuit according to any one of claims 1 to 5, wherein the heat resistance layer (B) is a layer made of either zinc or zinc alloy, and the zinc alloy contains, as the alloy element, one or more types selected from a group of a platinum group element, gold, a palladium group element and silver.

7. The rolled copper foil or electrolytic copper foil for an electronic circuit according to any one of claims 1 to 6, further comprising a chromium layer or a chromate layer and/or a silane treated layer on the heat resistance layer (8).

8. A method of forming an electronic circuit by etching a copper foil of a copper clad laminate made of a rolled copper foil or an electrolytic copper foil, wherein a layer of one type of metal of a platinum group, gold or silver, or a layer of an alloy having the foregoing metal as its main component with an etching rate that is lower than copper is formed on an etching surface side of the copper foil, and the copper foil is etched using an aqueous ferric chloride solution or an aqueous copper chloride solution to remove any unwanted portion of the copper so as to form a copper circuit.

9. A method of forming an electronic circuit by etching a copper foil of a copper clad laminate made of a rolled copper foil or an electrolytic copper foil, wherein the rolled copper foil or the electrolytic copper foil for an electronic circuit according to any one of claims 1 to 8 is used to prepare a copper clad laminate with the layer (A) with a lower etching rate as the etching surface, and the copper foil is etched with an aqueous ferric chloride solution or an aqueous copper chloride solution to remove any unwanted portion of the copper so as to form a copper circuit.
